# EUROPEAN PATENT SPECIFICATION

(11) **EP 0 429 847 B1**
(45) Date of publication and mention of the grant of the patent: **11.01.1995**
(21) Application number: 90120287.9
(22) Date of filing: 23.10.1990
(51) Int. Cl.: C30B 15/30, C30B 29/06

(54) **Method for pulling up single crystal silicon**
Verfahren zur Ziehung eines Siliciumeinkristalles
Procédé pour le tirage de silicium monocristallin

(30) Priority: 23.10.1989 JP 276481/89
(43) Date of publication of application: 05.06.1991
(73) Proprietor: SHIN-ETSU HANDOTAI COMPANY LIMITED, Chiyoda-ku Tokyo (JP)
(72) Inventor: Kodama, Yoshihiro, Ryokufu-Dormitory, Nishishirakawa-gun, Fukushima-ken (JP); Ishidaira, Tetsuya, Nishishirakawa-gun, Fukushima-ken (JP); Kanno, Koji, Shirakawa-shi, Fukushima-ken (JP); Furuse, Shinichi, Nishishirakawa-gun, Fukushima-ken (JP)
(74) Representative: Patentanwälte Leinweber & Zimmermann

(56) References cited:
- EP-A- 0 055 619
- FR-A- 2 413 124
- IBM TECHNICAL DISCLOSURE BULLETIN, vol. 17, no. 3, August 1974, pages 903-904, New York, US; H. MUELLER-KRUMBHAAR et al.: "Controlled crystal pulling with accelerated crucible rotation"
- JOURNAL OF CRYSTAL GROWTH, vol. 49, no. 2, June 1980, pages 291-296, Amsterdam, NL; C. SCHEEL et al.: "Crystal pulling using ACRT"

## Description

### BACKGROUND OF THE INVENTION

### 1. Field of the Invention:

This invention relates to a method of pulling up an ingot of single crystal silicon by the Czochralski process, and more particularly to a method of simultaneously equalizing oxygen concentrations of a grown single crystal silicon rod in its axial and radial directions.

### 2. Description of the Related Art:

According to the Czochralski process, a single crystal silicon rod is produced by heating and melting polycrystalline silicon in a quartz crucible, inserting a small seed crystal into the silicon melt, and gradually pulling up the seed crystal so as to grow the single crystal silicon rod. The quartz crucible is in contact with the silicon melt (about 1450°C) and its surface dissolves into the silicon melt. A part of the dissolved oxygen in the silicon melt is evaporated and the rest is incorporated into the single crystal rod.

Generally a single crystal silicon rod which has been pulled up by the conventional Czochralski process has non-uniform oxygen concentration. To be more specific, the part of the single crystal silicon rod which has been initially solidified in the axial direction has a higher oxygen concentration while the part solidified at a later stage has a lower oxygen concentration. For instance, the former oxygen concentration is 3 x 10¹⁸ atoms/cc while the latter oxygen concentration is 6 x 10¹⁷ atoms/cc at the last stage of the solidification. The single crystal silicon rod has the highest oxygen concentration at its central part of the radial direction and the lowest concentration at its periphery. The oxygen concentration of the radial direction is variable by as large as 15% of the central part.

Oxygen dissolved in single crystal silicon generates microdefects during heat treatment. If they occur in an active region of the surface of silicon wafers, the microdefects serve as nucleation sites for producing stacking faults during thermal oxidation processes. These stacking faults would deteriorate electric characteristics of electronic devices fabricated with a semiconductor substrate. However, recently such microdefects are intentionally generated within a semiconductor substrate except for the surface regions so as to actively use them as gettering sites for impurities and to make active regions free from defects. Oxygen dissolved in single crystal silicon is indispensable to this purpose. The above mentioned process is called an intrinsic gettering process and is one of the most indispensable techniques for manufacturing semiconductor integrated circuits.

The concentration of oxygen dissolved in a single crystal silicon rod is required to be as uniform as possible in its axial and radial directions. The concentration of oxygen in the single crystal silicon rod is controlled by the following methods; (1) a method using a fluid friction in the vicinity of solid-liquid interface by periodically and completely interrupting the rotation of a quartz crucible (Japanese Patent Publication No.29,677/1978), (2) a method of rotating the quartz crucible at a constant speed and additionally periodically accelerating and decelarating the crucible and /or the single crystal silicon rod (IBM Technical Disclosure Bulletin, Vol.17, No.3, August 1974, p. 903-904), (3) a method rotating the quartz crucible at a speed in reverse proportion to an oxygen concentration profile determined on a single crystal silicon rod (Japanese Patent Publication No, 6911/1985), and (4) a method rotating a single crystal silicon rod and the quartz crucible in the reverse directions to each other, and rotating the single crystal silicon rod at a speed faster than that of the quartz crucible, and increasing the rotation speed of the crucible in accordance with the length of the single crystal silicon rod (Japanese Laid-open Patent Publication No. 135796/1982; EP-A-0055619). Any of these methods are insufficient for the aforementioned purpose.

With the method (1), it is required to interrupt the rotation of the crucible momentarily and completely. However, as the crucible has become larger recently so as to receive more molten material, the momentary and complete interruption of the rotation is almost impossible. If the crucible was stopped completely, the molten material would become thermally instable, sometimes causing undesirable solidification of part of the molten material at the bottom of the crucible. The above drawback can be overcome by method (2). However, neither the momentary and complete interruption of rotation according to method (1) nor avoiding complete interruption of the crucible rotation according to method (2) can improve the profile of the oxygen concentration of the single crystal silicon rod in its axial direction.

With the method (3), when the oxygen concentration profile is decreased in the axial direction of the crystal silicon rod, the crucible is rotated at a higher speed. It is very complicated and practically difficult to determine the profile of a suitable rotation speed of the crucible. In addition, the oxygen concentration profile is not improved in the radial cross-sectional area of the crystal silicon rod.

The method (4), which is similar to the method (3), corresponds to such a process as the oxygen concentration profile decreases uniformly in the single crystal silicon rod in the method (3), considering only the rotation speed of the crucible. In this method, the single crystal silicon rod is rotated in a direction opposite to that of the crucible at a speed which is faster than that of the crucible. The process is not always effective to improve the oxygen concentration profile in the radial cross-sectional area of the silicon rod.

### SUMMARY OF THE INVENTION

It is therefore an object of this invention to provide a method of effectively controlling the oxygen concentration profile to less than 10 %, preferably less than 5 %, in both the axial and radial directions of a single crystal silicon rod pulled up from a crucible by the Czochralski process.

According to this invention, there is provided a method for pulling up a single crystal silicon rod comprising pulling up, by the Czochralski process, an ingot of single crystal silicon from a silicon melt in a quartz crucible rotating at a standard rotational speed; and adding pulse-like speed variations to the standard rotation speed of the crucible.

The inventive method is characterized by the steps of gradually increasing the standard rotation speed of the crucible in accordance with a predetermined operational sequence as the ingot of single crystal silicon is being pulled up from the crucible; and determining a magnitude and a cycle of the pulse-like speed variations to be added, to the standard rotation speed of the crucible in accordance with a predetermined operational sequence so as to establish a uniform oxygen concentration in the single crystal silicon rod in the axial and in the radial directions.

The magnitude of the pulse-like speed variations to be added to the standard rotation speed of the crucible is preferably set to a fixed value.

The pulse-like speed variations are preferably periodically added to the standard rotational speed of the crucible.

The magnitude of the pulse-like speed variations to be added to the standard rotation speed of the crucible is preferably set, so as to become larger as the ingot of single crystal silicon is being pulled up.

The period of time maintaining the addition of the pulse-like speed variations to be added to the standard rotation speed of the crucible and the subsequent period of time maintaining the standard rotation speed of the crucible without adding the said pulse-like speed variations are both favorably increased.

The standard rotation speed of the crucible is optionally determined between 0.1 rpm and 50 rpm. With the standard speed of 0.1 rpm or less, the temperature of the molten material will not be uniform in the crucible. In some cases, part of the silicon melt is solidified at the bottom of the crucible. With the standard rotation speed of 50 rpm or more, the molten material may vibrate and causes ripples on its surface, thereby making it difficult to pull up a single crystal silicon rod.

According to a first aspect of the invention, the standard rotation speed is set for 8 rpm or 10 rpm at first. As a crystal silicon rod is being pulled up, the rotation speed of the crucible is gradually increased and thereto pulse-like speed variations, viz., stepwise increasing or decreasing of the rotation speed, are added or superimposed periodically over a period of time. Usually the rotation speed may be set in a range between 0.1 and 50 rpm. It is desirable that the total rotation speed of the crucible (the standard rotation speed plus the range of rotation speed variations) should be actually 50 rpm at maximum depending upon the ordinary rotational mechanism, unavoidable eccentricity of the crucible rotation and other factors. Therefore, the maximum rotation speed to be added is about 42 rpm when the standard rotation speed is 8 rpm.

When the rotation speed of the crucible is gradually increased as the crystal silicon rod is being pulled up, the oxygen concentration of the silicon rod can be made uniform in its axial direction as known in the prior art, while that in the radial cross-sectional area cannot be improved. However if the pulse-like speed variations is added or superimposed to the above known rotation speed changing manner, the oxygen concentration can be made uniform simultaneously in both the axial and radial directions of the silicon rod.

The pulse-like rotation speed variations of the crucible contributes not only to uniform distribution of the oxygen concentration but also is useful to increase or decrease the oxygen concentration level.

If either, or both, the period of time maintaining the pulse-like rotation speed and/or, the period of time maintaining the preceding or subsequent standard rotation speed were to be increased, the oxygen concentration profile of the silicon rod in the axial direction increases as a whole compared with that when the above additional pulse-like rotation speed variation is not superimposed. The period of time maintaining the pulse-like rotation speed increase is optionally set in the range between 1 to 600 seconds. Increase of the oxygen concentration of the single crystal silicon rod is not observed outside the range mentioned above. The preferable period of time is 10 to 180 seconds.

When the period of time maintaining the rotation speed increase is short, the molten material cannot follow the movement of the crucible. When the period of time is too long, the oxygen concentration cannot become uniform in the cross-sectional area of the single crystal silicon rod. The ratio between the period of time maintaining the pulse-like rotation variations and the period of time maintaining preceding or subsequent standard rotation speed is between 1 : 99 and 99 : 1. To attain the optimum effect, the ratio is preferably between 2 : 8 and 8 : 2. It is also acceptable to lengthen the period of time maintaining the each pulse-like rotation speed increase and to increase the rotation speed simultaneously as the single crystal silicon rod is being pulled up.

According to the present invention, the adding manner of the pulse-like speed change is decided in accordance with the oxygen concentration profile of the single crystal silicon rod at the standard rotation speed of the crucible. The profile of the oxygen concentration of the single crystal silicon rod profile can be easily changed in the axial direction by adjusting the amount, namely, height and time of the pulse form of the rotation speed variations. The oxygen concentration profile can be 10% or less or 5% or less in the radial direction of the single crystal silicon rod as well.

The above and other advantages, features and additional objects of this invention will be manifest to those skilled in the art upon making reference to the follwing detailed description and the accompanying drawings.

### BRIEF DESCRIPTION OF THE DRAWINGS

FIG. 1 is a graph showing a rotation speed of a quartz crucible in Example 1; and
FIG. 2 is a graph showing the oxygen concentration in the lengthwise direction of a single crystal silicon rod produced in Example 1 and Comparative Experiment 1.

### DETAILED DESCRIPTION

### Example 1:

This example was obtained by changing the standard rotation speed while maintaining the magnitude of speed variation at 4.0 rpm, speed variation cycle at 60 seconds (period of standard rotation speed/period of increased rotation speed= 1/1).

A single crystal silicon ingot of 40 cm long was pulled up from a quartz crucible having an inner diameter of 440 mm in which silicon of 30 kg was melted. The quartz crucible was rotated at the following speeds.

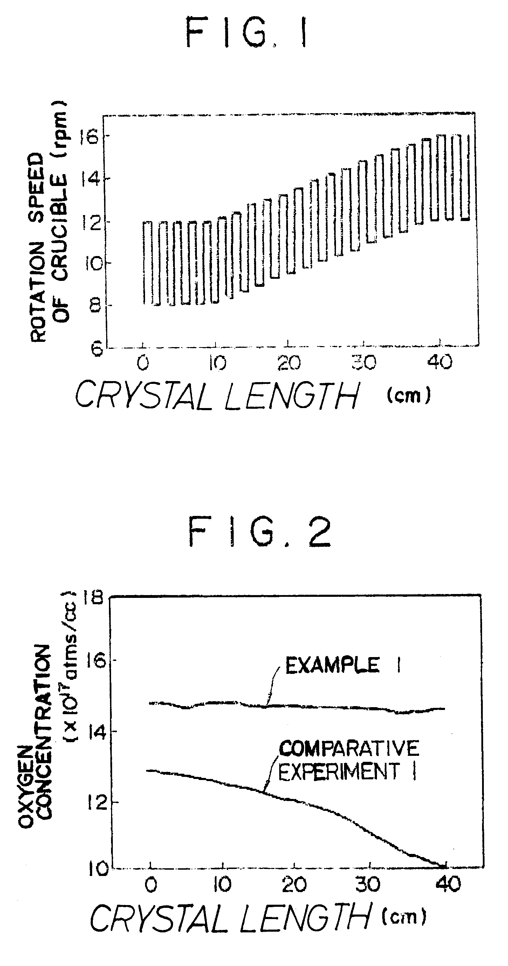

As shown in Fig. 1, the standard rotation speed of the crucible was kept at 8.0 rpm while the silicon rod was 0 to 10 cm long. The standard speed was gradually increased from 8 rpm to 12 rpm while the silicon rod was 10 to 40 cm long. The standard speed was increased to at a constant speed of 12.0 rpm when the silicon rod became longer than 40 cm. The magnitude of the speed variation was kept at 4.0 rpm, the speed variation cycle was 60 seconds (the period of the standard rotation speed/the period of the increased rotation speed = 1/1). The silicon rod was rotated at a speed (SR) of 20 rpm in the direction opposite to that of the crucible.

FIG. 2 shows the oxygen concentration of the single crystal silicon in its lengthwise direction. As can be seen in FIG. 2, the oxygen concentration obtained in this example is much improved compared with the Comparative Experiment 1 to be described later. The silicon rod obtained in this example was free from a phenomenon in which the oxygen concentration tends to decrease as the silicon rod gets longer, and had a uniform oxygen concentration in the lengthwise direction of the silicon rod. In addition, all the oxygen concentrations measured at a center and two 5mm points on a diameter from the periphery were within 4.5% of the lowest of them, across the cross-section at the center of the whole length of the silicon rod.

### Comparative Experiment 1:

This comparative experiment was produced without changing the standard speed of a quartz crucible (prior art).

A single crystal silicon rod of about 40 cm long and 150 mm in diameter was pulled up from the quartz crucible which had an inner diameter of 440 mm and in which silicon was melted. The crucible was rotated at the constant standard speed of 8.0 rpm without any speed variation.

The oxygen concentration of the produced silicon was measured. The result was shown in FIG. 2 as the Comparative Experiment 1 with that of Example 1. The oxygen concentrations measured at a center and two 5 mm points on a diameter from the periphery spread to 18% of the lowest of them.

As described above, according to this invention, (a) a single crystal silicon rod having a high oxygen concentration can be easily pulled up; (b) the oxygen concentration can be uniform in the radial and axial directions of the silicon rod; and (c) the standard rotation speed of the crucible is gradually increased and also there to the pulse-like rotation speed variations are added. Single crystal silicon rods having the desired oxygen concentration profile in both the axial and radial directions can be manufactured according to the amount of the change of the standard rotation speed and the adding effect of the pulse-like rotation speed variations.

## Claims

1. A method for pulling up a single crystal silicon rod comprising:
(a) pulling up, by the Czochralski process, an ingot of single crystals silicon from a silicon melt in a quartz crucible rotating at a standard rotation speed; and
(b) adding pulse-like speed variations to the standard rotation speed of the said crucible;
characterized by
(c) gradually increasing the standard rotation speed of the said crucible in accordance with a predetermined operational sequence as the ingot of the single crystal silicon is being pulled up from the said crucible; and
(d) determining a magnitude and a cycle of the pulse-like speed variations to be added to the standard rotation speed of the said crucible in accordance with a predetermined operational sequence
so as to establish a uniform oxygen concentration in the single crystal silicon rod in the axial and in the radial directions.

2. A method for pulling up a single crystal silicon rod according to Claim 1, wherein the magnitude of the pulse-like speed variations to be added to the standard rotation speed of the said crucible is set to a fixed value.

3. A method for pulling up a single crystal silicon rod according to Claim 1 or 2, wherein the pulse-like speed variations are periodically added to the standard rotation speed of the said crucible.

4. A method for pulling up a single crystal silicon rod according to Claim 3, wherein the magnitude of the pulse-like speed variations to be added to the standard rotation speed of the said crucible is set so as to become larger as the ingot of single crystal silicon is being pulled up.

5. A method for pulling up a single crystal silicon rod according to Claim 3, wherein the period of time maintaining the addition of the pulse-like speed variation to be added to the standard rotational speed of the said crucible and the subsequent period of time maintaining the standard rotation speed of the said crucible without adding the said pulse-like speed variations are both increased.

6. A method according to any of the preceding claims, wherein the rotation speed of the crucible is in the range between 0.1 rpm and 50 rpm.

7. A method according to any of the preceding claims, wherein the period of time maintaining the addition of pulse-like speed variation to be added to the standard rotation speed is in the range between 1 to 600 seconds and preferably in the range between 10 to 180 seconds.

## Patentansprüche

1. Verfahren zum Ziehen eines Silizium-Einkristallstabes umfassend:
a) Ziehen eines Blocks eines Silizium-Einkristalls aus einer Siliziumschmelze in einem sich mit einer Standarddrehgeschwindigkeit drehenden Tiegel mit dem Czochralski-Verfahren und
b) Aufgeben impulsartiger Geschwindigkeitsänderungen auf die Standarddrehgeschwindigkeit des Tiegels;
gekennzeichnet durch
c) allmähliches Erhöhen der Standarddrehgeschwindigkeit des Tiegels gemäß einer vorab festgelegten Betriebsfolge, während der Block des Silizium-Einkristalls aus dem Tiegel gezogen wird und
d) Festlegen einer Amplitude und eines Zyklus der auf die Standarddrehgeschwindigkeit des Tiegels aufzugebenden Geschwindigkeitsänderungen gemäß einer vorab festgelegten Betriebsfolge zum Herstellen einer einheitlichen Sauerstoffkonzentration in dem Silizium-Einkristallstab in axialer Richtung und in radialer Richtung.

2. Verfahren zum Ziehen eines Silizium-Einkristallstabes nach Anspruch 1, bei dem die Amplitude der auf die Standarddrehgeschwindigkeit des Tiegels aufzugebenden, impulsartigen Geschwindigkeitsänderungen auf einen festgelegten Wert eingestellt ist.

3. Verfahren zum Ziehen eines Silizium-Einkristallstabes nach Anspruch 1 oder 2, bei dem die impulsartigen Geschwindigkeitsänderungen periodisch auf die Standarddrehgeschwindigkeit des Tiegels aufgegeben werden.

4. Verfahren zum Ziehen eines Silizium-Einkristallstabes nach Anspruch 3, bei dem die Amplitude der auf die Standarddrehgeschwindigkeit des Tiegels aufzugebenden, impulsartigen Geschwindigkeitsänderungen so eingestellt wird, daß sie größer wird, während der Silizium-Einkristallblock gezogen wird.

5. Verfahren zum Ziehen eines Silizium-Einkristallstabes nach Anspruch 3, bei dem sowohl die Zeitdauer des Aufrechterhaltens der Aufgabe der auf die Standarddrehgeschwindigkeit des Tiegels aufzugebenden, impulsartigen Geschwindigkeitsänderung als auch die darauffolgende Zeitdauer des Aufrechterhaltens der Standarddrehgeschwindigkeit des Tiegels ohne Aufgeben der impulsartigen Geschwindigkeitsänderungen erhöht wird.

6. Verfahren nach einem der vorhergehenden Ansprüche, bei dem die Drehgeschwindigkeit des Tiegels im Bereich zwischen 0,1 U/min und 50 U/min liegt.

7. Verfahren nach einem der vorhergehenden Ansprüche, bei dem die Zeitdauer des Aufrechterhaltens der Aufgabe der auf die Standarddrehgeschwindigkeit aufzugebenden, impulsartigen Geschwindigkeitsänderung im Bereich zwischen 1 und 600 Sekunden und vorzugsweise im Bereich zwischen 10 und 180 Sekunden liegt.

## Revendications

1. Procédé pour le tirage d'une tige en silicium monocristallin consistant à :
(a) tirer, par le procédé de Czochralski, un lingot de silicium monocristallin d'un silicium fondu dans un creuset en quartz tournant à une vitesse de rotation standard ; et
(b) ajouter des variations de vitesse ressemblant à des impulsions, à la vitesse standard de rotation dudit creuset ;
caractérisé en ce que
(c) on augmente graduellement la vitesse de rotation standard dudit creuset selon une séquence opérationnelle prédéterminée tandis que le lingot du silicium monocristallin est tiré dudit creuset ; et
(d) on détermine la grandeur et le cycle des variations de vitesse ressemblant à des impulsions à ajouter à la vitesse standard de rotation dudit creuset selon une séquence opérationnelle prédéterminée.
afin d'établir une concentration uniforme en oxygène dans la tige en silicium monocristallin,dans les directions axiale et radiale.

2. Procédé pour le tirage d'une tige en silicium monocristallin selon la revendication 1, où la grandeur des variations de vitesse ressemblant à des impulsions à ajouter à la vitesse standard de rotation dudit creuset est établie à une valeur fixe.

3. Procédé pour le tirage d'une tige en silicium monocristallin selon la revendication 1 ou 2, où les variations de vitesse ressemblant à des impulsions sont périodiquement ajoutées à la vitesse standard de rotation dudit creuset.

4. Procédé pour le tirage d'une tige en silicium monocristallin selon la revendication 3, où la grandeur des variations de vitesse ressemblant à des impulsions à ajouter à la vitesse standard de rotation dudit creuset est établie de façon à devenir plus importante tandis que le lingot du silicium monocristallin est tiré.

5. Procédé pour le tirage d'une tige en silicium monocristallin selon la revendication 3, où le temps de maintien de l'addition de la variation de vitesse ressemblant à des impulsions à ajouter à la vitesse standard de rotation dudit creuset et le temps subséquent de maintien de la vitesse standard de rotation dudit creuset sans ajouter lesdites variations de vitesse ressemblant à des impulsions, sont augmentés.

6. Procédé selon l'une quelconque des revendications précédentes,où la vitesse de rotation du creuset est comprise entre 0,1 t/mn et 50 t/mn.

7. Procédé selon l'une quelconque des revendications précédentes, où le temps de maintien de l'addition de la variation de vitesse ressemblant à des impulsions à ajouter à la vitesse standard de rotation, est compris entre 1 et 600 secondes et, de préférence, entre 10 et 180 secondes.
